Europäisches Patentamt

European Patent Office

Office européen des brevets

(11) Publication number: **0 276 788 B1**

# EUROPEAN PATENT SPECIFICATION

(45) Date of publication of patent specification: **13.01.93**

(51) Int. Cl.5: **C04B 41/88**, H01L 21/84, H01L 23/29, H01L 23/31, H01L 23/36, //C04B35/58

(21) Application number: **88101015.1**

(22) Date of filing: **25.01.88**

(54) **Aluminium nitride sintered body formed with metallized layer and method of manufacturing the same.**

(30) Priority: **26.01.87 JP 16421/87**
　　　　　**26.01.87 JP 16422/87**

(43) Date of publication of application:
**03.08.88 Bulletin 88/31**

(45) Publication of the grant of the patent:
**13.01.93 Bulletin 93/02**

(84) Designated Contracting States:
**DE FR GB IT**

(56) References cited:
**EP-A- 0 217 584**
**EP-A- 0 235 682**
**US-A- 4 695 517**

**SOVIET INVENTIONS ILLUSTRATED, Section C, Week E13, 12th May 1982, Abstract no. 25722, Classes L02, M13, Derwent Publications Ltd., London, GB & SU-A-833883**

(73) Proprietor: **SUMITOMO ELECTRIC INDUS-TRIES, LTD.**
**5-33, Kitahama 4-chome, Chuo-ku**
**Osaka-shi, Osaka 541(JP)**

(72) Inventor: **Sasame, Akira c/o Itami Works**
**Sumitomo Electric Ind. Ltd. 1-1, Koyakita**
**1-chome**
**Itami-shi Hyogo-ken(JP)**
Inventor: **Sakanoue, Hitoyuki c/o Itami Works**
**Sumitomo Electric Ind. Ltd. 1-1, Koyakita**
**1-chome**
**Itami-shi Hyogo-ken(JP)**

(74) Representative: **Patentanwälte Kirschner & Grosse**
**Forstenrieder Allee 59**
**W-8000 München 71(DE)**

**Description**

BACKGROUND OF THE INVENTION

Field of the Invention

The present invention relates to an aluminum nitride sintered body on the surface of which is formed a metallized layer of tungsten or molybdenum and a method of manufacturing the same. The aluminum nitride sintered body is applied to a package for a semiconductor device etc., to be mounted with a semiconductor element of high calorific power.

Description of the Prior Art

In general, an insulating substrate, which is applied to a package for a semiconductor device etc. is prepared from alumina ($Al_2O_3$). A lead flame is generally prepared using an iron-nickel alloy such as Kovar (trade name of Fe-29%Ni-17%Co alloy) or 42 alloy [Fe-42%Ni), to be brazed to a metal layer part of the insulating substrate, which is provided with a circuit, by silver solder or the like, for application to a package for a semiconductor device.

However, although alumina is excellent in electric insulability and mechanical strength, the heat dissipation property thereof is inferior due to its small thermal conductivity of 30 W/mK. Thus, it is improper to carry a field-effect transistor (FET) of high calorific power, for example, on an alumina substrate. In order to carry a semiconductor element of high calorific power, another type of insulating substrate is prepared from beryllia (BeO) having high thermal conductivity of 250 W/mK, however beryllia is toxic and hence it is troublesome to take safety measures in the employment of such an insulating substrate.

In recent years, nontoxic aluminum nitride (AIN) has generated great interest as a material for such an insulating substrate for carrying a semiconductor element of high calorific power because of its high thermal conductivity of 220 W/mK, this value is nearly equal to that of beryllia, as well as its electric insulability and mechanical strength which are equivalent to those of alumina.

A sintered body of aluminum nitride (AIN), having high thermal conductivity and excellent mechanical strength, is being watched as a material which is applicable to an insulating substrate for a semiconductor integrated circuit device (IC) and a substrate for forming an electric circuit, such as a power module. However, since such an aluminum nitride sintered body is inferior in its wetting property with a metal, sufficient adhesive strength cannot be obtained in the lamination of a metal layer on the surface thereof for employing the same as a substrate for a semiconductor integrated circuit such as a power transistor. Although various attempts have been made to metallize the surfaces of such AIN sintered compacts, no satisfactory method has been proposed for the present.

Technique relating to such an aluminum nitride sintered body is disclosed in U.S. Patent No. 4547471, for example. Further, Japanese Patent Laying-Open Gazette No. 121175/1984, for example, discloses a method of metallizing the surface of an aluminum nitride sintered body obtained through the said technique. This prior art discloses employment of general molybdenum paste and copper paste, although compositions thereof are not concretely defined. Japanese Patent Laying-Open Gazette No. 132580/1986 discloses a method of metallizing a nitride ceramic body which is formed on its surface with a metallized layer prepared by adding Mo, W, Mn etc. to MgO, AIN, $Y_2O_3$ or $SiO_2$. Japanese Patent Laying-Open Gazette No. 105972/1987 discloses a method of forming a cracked oxide layer on the surface of an aluminum nitride sintered body and thereafter coating a vitreous adhesive agent on the surface of the oxide layer.

Further, Japanese Patent Laying-Open Gazette No. 75208/1975 discloses a method of metallizing the surface of an aluminum nitride sintered body by oxidizing the surface of the aluminum nitride sintered body and sintering a metal such as Mo, W, Mn or Ti on the surface thereof. Japanese Patent Laying-Open Gazette No. 102310/1978 discloses a heat-conductive substrate which comprises a sintered substrate of aluminum nitride system and a metal layer of Mo, W, Mo-W system or Mo-Mn system formed through a metal oxide layer such as an oxide layer containing $SiO_2$, $Al_2O_3$, MgO, CaO or $Fe_2O_3$, for example, formed on a prescribed surface of the substrate.

On the other hand, Telefunkeen method of coating paste of tungsten or tungsten-manganese (or molybdenum or molybdenum-manganese) on the surface of a sintered body and firing the same in wet hydrogen or wet $H_2$-$N_2$ mixturedgas at a temperature of 1300 to 1700°C is well known as technique of metallizing a sintered body of aluminum oxide ($Al_2O_3$).

This method is characterized in that the $Al_2O_3$ sintered body is fired in a wet atmosphere at a temperature for softening glassy phase in the $Al_2O_3$ sintered compact. The surface of W and/or Mn is

2

oxidized by such firing, to accelerate sintering of the paste of W or W-Mn. Oxides of such materials are dissolved in the glassy phase of the sintered body to improve fluidity of the glass, whereby the glassy phase is transferred to a porous metallized layer of W or W-Mn. Further, the oxides generated by the firing, particularly MnO reacts with $Al_2O_3$ and $SiO_2$ contained in the sintered body, to form $MnO \cdot Al_2O_3$ and $MnO \cdot SiO_2$. Similarly, W is partially oxidized to generate tungsten oxide, which reacts strongly with alumina. Thus, the metallized layer of W or W-Mn (or Mo or Mo-Mn) is strongly adhered to the $Al_2O_3$ sintered body through mechanical and chemical bonding, with adhesive strength of about 4 to 7 $Kg/mm^2$.

Thus, it may be assumed that an AlN sintered body can be metallized through the aforementioned Telefunkeen method. According to the method, however, a metallized layer of W or W-Mn formed on the surface of an AlN sintered body has merely low adhesive strength and airtightness thereof is extremely inferior. Possible causes therefor are as follows:

(a) Since firing is performed in a wet atmosphere according to the Telefunkeen method, the surface of the AlN sintered body is corroded by steam or decomposed to form a fragile $Al_2O_3$ layer.

(b) Dissimilarly to the $Al_2O_3$ sintered body, the AlN sintered body is provided with no glassy phase etc. which is softened at a low temperature of about 1000 to 1500°C.

(c) AlN is inferior in reactivity with W, Mn and oxides thereof.

When the metallized layer formed on the surface of an AlN sintered body, which is applied to a substrate for a semiconductor integrated circuit device, it has low adhesive strength, the metallized layer is easily peeled through a heat cycle in the manufacturing steps. Further, insufficient airtightness of the metallized layer leads to inferior strength and insufficient sealing property.

In order to apply the Telefunkeen method to metallization of an AlN sintered body, the inventors have attempted to add glass or an assistant for an AlN sintered body such as $Y_2O_3$ or CaO to paste of W or W-Mn for firing the same in an inert atmosphere. However, it has been impossible to solve the aforementioned problem relating to adhesive strength and airtightness. In a method of employing glass, the metallized layer was not strongly adhered to the sintered body due to inferior wetting property of remaining W or Mn and AlN with glass. In a method of employing the assistant for an AlN sintered body such as $Y_2O_3$ or CaO, a reaction layer was slightly formed at a firing temperature of at least about 1600°C, whereas the metallized layer thus obtained was extremely porous and adhesive strength thereof was low since the assistant has a high melting point and no liquid phase was formed in the metallized layer.

EP-A-0 235 682, published after the priority date of the present invention discloses aluminium nitride sintered bodies having a conductive metallized layer comprising tungsten, aluminium oxide and calcium oxide or a calcium compound, the maximum calcium contents being 3,85 % by weight of calcium carbonate.

## SUMMARY OF THE INVENTION

The present invention has been proposed to overcome the aforementioned problem by further improving the above described prior art, and an object thereof is to provide an aluminum nitride sintered body formed with a metallized layer of tungsten or molybdenum, which is strongly adhered to the surface of the aluminum nitride sintered body with high thermal conductivity and excellent airtightness, and a method of manufacturing the same.

In the aluminum nitride sintered body formed with a metallized layer according to the present invention, the metallized layer contains at least a metal selected from tungsten and molybdenum, at least an aluminum compound selected from a group of aluminum nitride, aluminum oxide and aluminum oxynitride, and calcium oxide; taking into account EP-A-0 235 682 the invention further provides for the contracting States DE and GB that said metallized layer contains at least 3% by weight of calcium oxide when said metal is tungsten and said aluminium compound is aluminium oxide.

A method of forming a metallized layer on the surface of an aluminum nitride sintered body according to the present invention comprises:

(i) a step of preparing an aluminum nitride sintered body which is previously fired to be in a prescribed configuration;

(ii) a step of providing paste of at least a metal selected from tungsten and molybdenum, containing powder of at least a calcium compound selected from a group of calcium oxide, calcium nitrate and calcium carbonate and powder of at least an aluminum compound selected from a group of aluminum nitride, aluminum oxide and aluminum oxynitride;

(iii) a step of coating the metal paste on the surface of the aluminum nitride sintered body; and

(iv) a step of firing the aluminum nitride sintered body coated with the metal paste in an inert atmosphere.

In the present invention, it is believed that calcium oxide (CaO) (including that formed by decomposition of $CaCO_3$ or $Ca(NO_3)_2$ through firing) has high reactivity with an aluminum compound, to easily react with the aluminum compound contained in the metal paste at a temperature in excess of 1500°C, thereby to form liquid phase of these compounds. This liquid phase has high chemical affinity with W or Mo, whereby the same can be sufficiently fired in an inert atmosphere such as nitrogen without employing the firing step performed in a wet atmosphere as in the general Telefunkeen method, to obtain an excellent metallized layer. The liquid phase has extremely high wetting property and reactivity with an AlN sintered body, whereby the metallized layer is extremely strongly joined with the AlN sintered body. Further, the liquid phase penetrates grain boundary phase of W or Mo at a temperature in excess of 1500°C. In addition, the liquid phase extremely accelerates sintering of W or Mo, so that the metallized layer obtained after firing has excellent airtightness with no pores. According to the inventive manufacturing method, calcium oxide can be replaced by calcium nitrate or calcium carbonate, which is decomposed in firing to form calcium oxide, whereby similar function/effect is attained.

In the manufacturing method according to the present invention, powder of a calcium compound and that of an aluminum compound is mixed into paste of tungsten or molybdenum to be coated on the surface of an AlN sintered body, which in turn is fired in an inert atmosphere such as $N_2$ or Ar at a temperature of 1500 to 1800°C, so that CaO reacts with the aluminum compound and the reaction product is softened or molten to accelerate sintering. The reaction product simultaneously infiltrates into pores of a metallized layer of tungsten or molybdenum to be formed, thereby to increase mechanical bonding of the metallized layer and improve airtightness thereof. The reaction product reacts not only with AlN on the surface of the sintered body but with a sintering assistant component contained in grain boundary phase of AlN while causing mass transfer between the same and the grain boundary phase, thereby to increase adhesive strength of the metallized layer and the AlN sintered body and improve airtightness. Airtightness can be further improved by performing plating on the metallized layer using nickel or the like.

In a preferred embodiment of the aluminum nitride sintered body according to the present invention, the metallized layer formed on the surface thereof preferably contains 40 to 98 percent by weight of the metal, 1 to 25 percent by weight of the aluminum compound and 1 to 35 percent by weight of calcium oxide in general, although the above described function/effect can be obtained even if the respective contents of the aluminum compound and calcium oxide are small. If the contents of calcium oxide and the aluminum compound, serving as assistants, are further increased, another problem is caused although no influence is exerted on adhesive strength. In this case, a solution formed by reaction of the assistants is increased in volume to be deposited on the metal surface of tungsten or molybdenum, whereby plating performed on the metallized layer for improving airtightness may be degraded in adhesive property, to cause adhesive failure.

According to another preferred embodiment, the metallized layer may contain 1 to 10 percent by weight of the aluminum compound, being prepared by aluminum oxide, and 1 to 20 percent by weight of calcium oxide in case of employing tungsten as the metal. In case of employing molybdenum as the metal, the metallized layer may contain 1 to 10 percent by weight of the aluminum compound, being prepared by aluminum oxide, and 1 to 35 percent by weight of calcium oxide. In such case, excellent adhesive strength and thermal conductivity can be obtained between the aluminum nitride sintered body and the metallized layer.

When the metal used is tungsten and the aluminum compound used is aluminum oxide, the metallized layer to be formed may contain 1 to 10 percent by weight of aluminum oxide and 10 to 20 percent by weight of calcium oxide. When the metal used is molybdenum and the aluminum compound used is aluminum oxide, the metallized layer to be formed may contain 1 to 10 percent by weight of aluminum oxide and 15 to 35 percent by weight of calcium oxide. In this case, adhesive strength between the aluminum nitride sintered body and the metallized layer is at least around 7 $Kg/mm^2$.

A metallized layer containing 1 to 10 percent by weight of aluminum oxide and 3 to 15 percent by weight of calcium oxide in case of preparing the metal and the aluminum compound by using tungsten and aluminum oxide respectively, or a metallized layer containing 1 to 7 percent by weight of aluminum oxide and 1 to 35 percent by weight of calcium oxide in case of preparing the metal and the aluminum compound by using molybdenum and aluminum oxide respectively, is preferable in view of thermal conductivity, say (or thermal resistance.) The value of thermal resistance is used in order to evaluate thermal properties of a semiconductor device such as a transistor or a diode. This value generally shows the thermal resistance of the whole, including a semiconductor device such as a transistor, metallized layer, AlN sintered body and peripheral parts etc. Thus this thermal resistance value varies depending upon conditions such as shape or material of the semiconductor device. However, if the semiconductor device is under the same conditions, the thermal resistance value of a metallized layer becomes dominant over that of the integrated semiconductor device. Therefore, the whole thermal resistance of the device depends heavily on the properety of the metallized layer.

A metallized layer containing 1 to 5 percent by weight of aluminum oxide and 1 to 15 percent by weight of calcium oxide in case of preparing the metal and the aluminum compound by using tungsten and aluminum oxide respectively or a metallized layer containing 1 to 5 percent by weight of aluminum oxide and 1 to 25 percent by weight of calcium oxide in case of preparing the metal and the aluminum compound by using molybdenum aluminum oxide, is particularly excellent in adhesive property of plating performed on the surface thereof.

In the inventive method of forming a metallized layer on the surface of an aluminum nitride sintered body, the step of providing metal paste may be performed by kneading powder of a calcium compound, that of an aluminum compound and metal powder of tungsten or molybdenum, or previously mixing powder of a calcium compound and that of an aluminum compound, firing the mixture to provide a fired substance and kneading powder of the fired substance and metal powder of tungsten or molybdenum.

The aluminum nitride sintered body obtained according to the present invention is preferably applied to partially form a substrate of a package for a semiconductor device, if the metallized layer formed on its surface is excellent in adhesive strength. Further, the inventive aluminum nitride sintered body having formed on its surface a metallized layer, which is particularly excellent in thermal conductivity, is preferably applied to form a part of a heat sink for a semiconductor device. Further, the inventive aluminum nitride sintered body is preferably applied to form a part of a cap for airtightly sealing a package for a semiconductor device.

These and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a process drawing schematically showing an embodiment of a method of manufacturing an aluminum nitride sintered body according to the present invention;

Fig. 2 is a process drawing schematically showing another embodiment of a method of manufacturing an aluminum nitride sintered body according to the present invention;

Fig. 3 is a process drawing schematically showing still another embodiment of a manufacturing method according to the present invention, in case of applying the inventive aluminum nitride sintered body to a package for a semiconductor device etc.;

Figs. 4A, 4B and 4C are a plan view and sectional views showing an embodiment of an aluminum nitride sintered body according to the present invention, which is applied to a part of a substrate of a package for a semiconductor device;

Fig. 5 is a sectional view showing another embodiment of the aluminum nitride sintered body according to the present invention, which is applied to a part of a cap for airtightly sealing a package for a semiconductor device;

Fig. 6 is a sectional view showing still another embodiment of the aluminum nitride sintered body according to the present invention, which is applied to a heat sink for a semiconductor device such as a light emitting diode (LED) or a laser diode (LD);

Fig. 7 is a sectional view showing a further embodiment of the aluminum nitride sintered body according to the present invention, which is applied to a submount serving as a substrate for forming an electric circuit such as a hybrid integrated circuit device or a power module;

Fig. 8 is a diagram for illustrating a test for measuring adhesive strength of a metallized layer formed on the surface of an aluminum nitride sintered body according to the present invention;

Figs. 9A and 9B illustrate adhesive strength and thermal resistance of metallized layers in aluminum nitride sintered bodies obtained through Example 5 in terms of relation to contents of $Al_2O_3$ and CaO respectively; and

Figs. 10A and 10B illustrate adhesive strength and thermal resistance of metallized layers in aluminum nitride sintered bodies obtained through Example 6 in terms of relation to contents of $Al_2O_3$ and CaO respectively.

DESCRIPTION OF THE PREFERRED EMBODIMENTS

As described above, the present invention is directed to improve the technique of forming a metallized layer on the surface of an aluminum nitride sintered body. The aluminum nitride sintered body employed in the present invention is obtained by the following method, for example:

First, paraffin is added as a binder to powder of aluminum nitride containing 0.01 to 5 percent by weight of yttrium oxide, serving as a sintering assistant, and mixed with the same. Thereafter the mixture is formed in a prescribed configuration and the temperature thereof is raised up to 1950°C in a nitrogen atmosphere. The mixture is held at the said temperature for one hour to be sintered, thereby obtaining a substrate of the aluminum nitride sintered body, which is the object of the present invention. The sintered body preferably has thermal conductivity of at least 150 W/mK, in order to sufficiently effectuate the present invention. Thus, the sintered body preferably has a small lattice defect. Such a sintered body can be formed by raw materials of high purity through steps avoiding contamination by impurities.

The steps of forming a metallized layer on the surface of the aluminum nitride sintered body obtained by the aforementioned method are performed as follows:

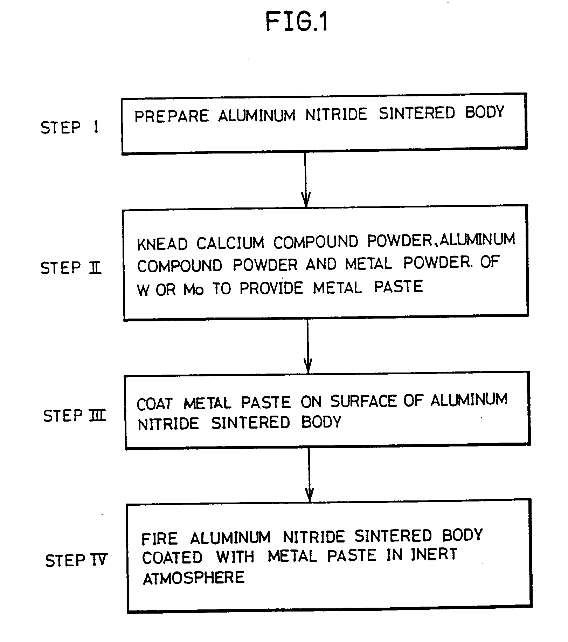

Referring to Fig. 1, an aluminum nitride sintered body is first prepared. A material for a metallized layer is prepared by kneading powder of a calcium compound, that of an aluminum compound and metal powder of tungsten or molybdenum with addition of an organic binder, to provide a metal paste. The metal paste thus provided is coated on the surface of the aluminum nitride sintered body. This aluminum nitride sintered body is fired in an inert atmosphere at a temperature of 1500 to 1800°C, to be formed with a metallized layer on its surface.

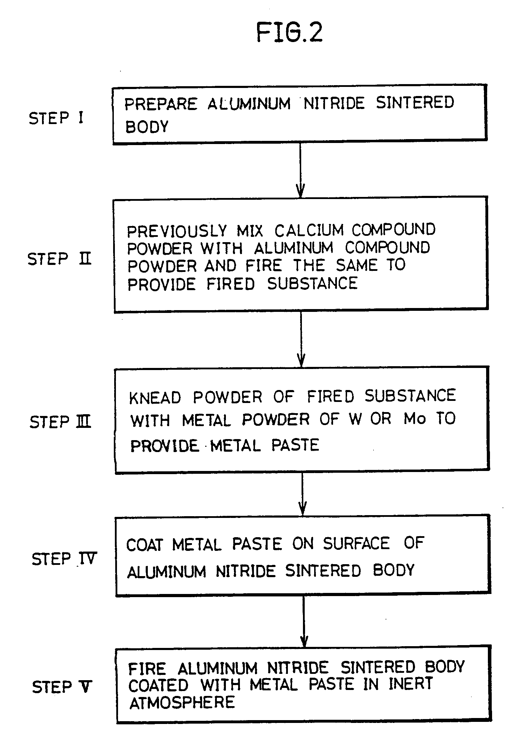

The step II as shown in Fig. 1 may be performed through a process including steps II and III as shown in Fig. 2. Referring to Fig. 2, a material for a metallized layer is prepared by previously mixing powder of a calcium compound and that of an aluminum compound and firing the same to provide a fired substance. The fired substance is pulverized to obtain powder, which is kneaded with metal powder of tungsten or molybdenum with addition of an organic binder, to provide metal paste. This metal paste is coated on the surface of an aluminum nitride sintered body. A further homogeneous metallized layer can be obtained by providing the metal paste through such steps. The previously prepared fired substance of calcium and aluminum compounds is obtained by firing the same at a temperature of 1200 to 1500°C.

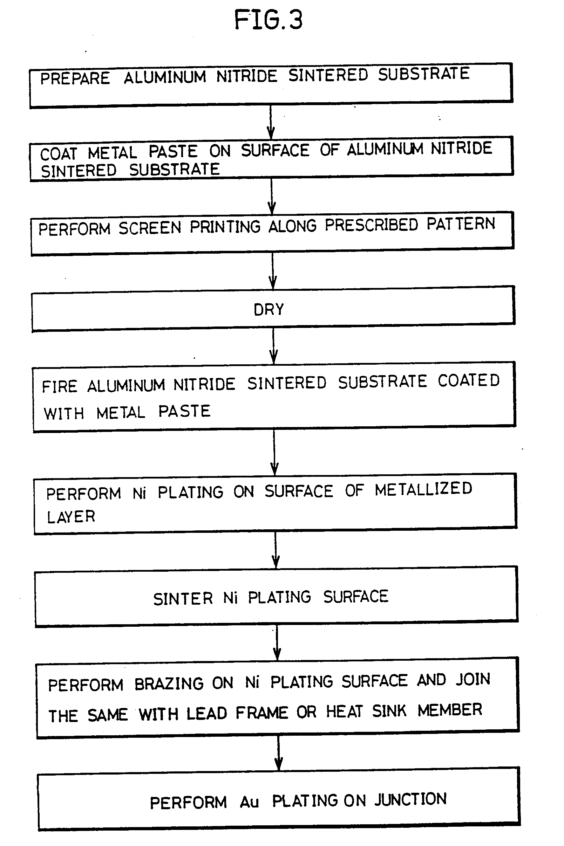

A method of forming a metallized layer on the surface of the aforementioned aluminum nitride sintered body is performed through the following steps, in case of applying the aluminum nitride sintered body to a package for a semiconductor device etc.: Referring to Fig. 3, an aluminum nitride sintered substrate is first prepared. Then, the metal paste obtained through the aforementioned method is coated on the surface of the aluminum nitride sintered substrate. The metal paste thus coated is subjected to screen printing processing along a predetermined prescribed pattern such as a circuit pattern. The metal paste thus subjected to screen printing is thereafter dried. Then the aluminum nitride sintered substrate is fired in an inert gas atmosphere which is heated to a prescribed temperature. After the firing step, nickel plating is performed on the surface of a metallized layer formed on the aluminum nitride sintered substrate. Heat treatment is performed at a temperature of about 900°C to sinter the nickel plating, thereby improving strength and airtightness of the same. Brazing is performed on the nickel plating surface in order to join the aluminum nitride sintered substrate with a lead frame, a heat sink member or the like. Further, gold plating is performed on the junction. Thus, the aluminum nitride sintered body according to the present invention can be manufactured to be applied to a substrate such as a package for a semiconductor device.

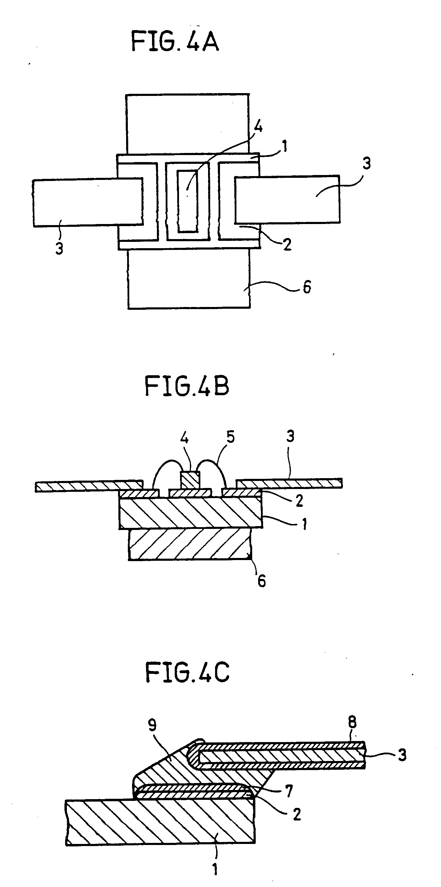

Fig. 4A is a plan view showing an embodiment of a substrate manufactured through the aforementioned steps to be applied to a package for a semiconductor device, Fig. 4B is a sectional view of the substrate and Fig. 4C is a sectional view showing a junction between a lead frame 3 and an aluminum nitride substrate 1 in detail. Referring to these figures, the aluminum nitride substrate 1, being implemented by the inventive aluminum nitride sintered body, is partially formed on its surface with a metallized layer 2 in accordance with the present invention, and the lead frame 3 is joined to the metallized layer 2 through brazing by a brazing metal or the like. A semiconductor element 4 such as an FET of high calorific power is carried on a prescribed position of the package for a semiconductor device, to be connected with the metallized layer 2 or the lead frame 3 by a bonding wire 5. Further, a heat sink 6 of Cu-W alloy is mounted on the back surface of the aluminum nitride substrate 1. As shown in Fig. 4C, a plating layer 7 is formed on the metallized layer 2 in the junction between the aluminum nitride substrate 1 and the lead frame 3, while a plating layer 8 is formed at need on the surface of the lead frame 3, in order to stabilize wettability of a brazing metal 9.

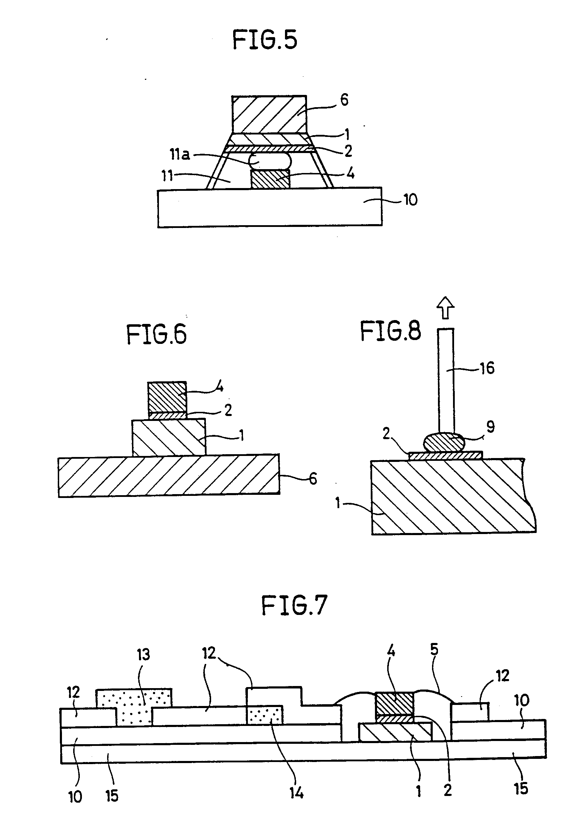

The inventive aluminum nitride sintered body can also be applied to a part of a cap for airtightly sealing a semiconductor device. Referring to Fig. 5, a semiconductor element 4 is carried on an Al$_2$O$_3$ substrate 10. A cap formed by a frame 11 of Kovar (trade name of Fe-Ni29%-Co17% alloy) and an aluminum nitride sintered body 1 joined thereon is provided above the semiconductor element 4. The aluminum nitride sintered body 1 is formed with a metallized layer 2 on its surface closer to the frame 11. A compound 11a such as thermal conductive resin lies between the semiconductor element 4 and the metallized layer 2. A heat sink 6 is mounted on the aluminum nitride sintered body 1 to readily dissipate heat generated by the semiconductor element 4.

The inventive aluminum nitride sintered body can be further applied to a beat sink member. Referring to Fig. 6, an aluminum nitride substrate 1 is mounted on a heat sink 6 of Cu-W alloy, and a semiconductor element 4 such as a light emitting diode (LED) or a laser diode (LD) is joined on the aluminum nitride substrate 1. The semiconductor element 4 is joined on a metallized layer 2 which is formed on the surface of the aluminum nitride substrate 1. In this case, the aluminum nitride substrate 1 serves as a heat sink member.

The inventive aluminum nitride sintered body can also be applied to a substrate for forming an electric circuit such as a hybrid integrated circuit device or a power module. Fig. 7 shows an aluminum nitride substrate 1, which is applied to a submount for a semiconductor element in a hybrid semiconductor integrated circuit device (IC). Referring to Fig. 7, an $Al_2O_3$ substrate 10 is formed on a copper substrate 15. A conductor layer 12, serving as an interconnection layer, is formed on the $Al_2O_3$ substrate 10, while a resistor 13, a capacitor 14 and the like are assembled between the same to form a circuit. The conductor layer 12 and the semiconductor element 4 are joined with each other by a bonding wire 5. The semiconductor element 4 is mounted on the copper substrate 15 through the aluminum nitride substrate 1. The semiconductor element 4 and the aluminum nitride substrate 1 are joined with each other through a metallized layer 2 which is formed on the surface of the aluminum nitride substrate 1. In this case, heat generated by the semiconductor element 4 is transferred to the aluminum nitride substrate 1, and further transmitted to the copper substrate 15 provided under the same, to be thus dissipated. In general, a substrate of beryllia (BeO) is employed in place of the aluminum nitride substrate 1.

Description is now made on Examples 1 to 7, each sample of which was prepared by cutting a substrate of an aluminum nitride sintered body obtained by the aforementioned method in the size of 10 mm x 10 mm x 1 mm and polishing the same.

Example 1

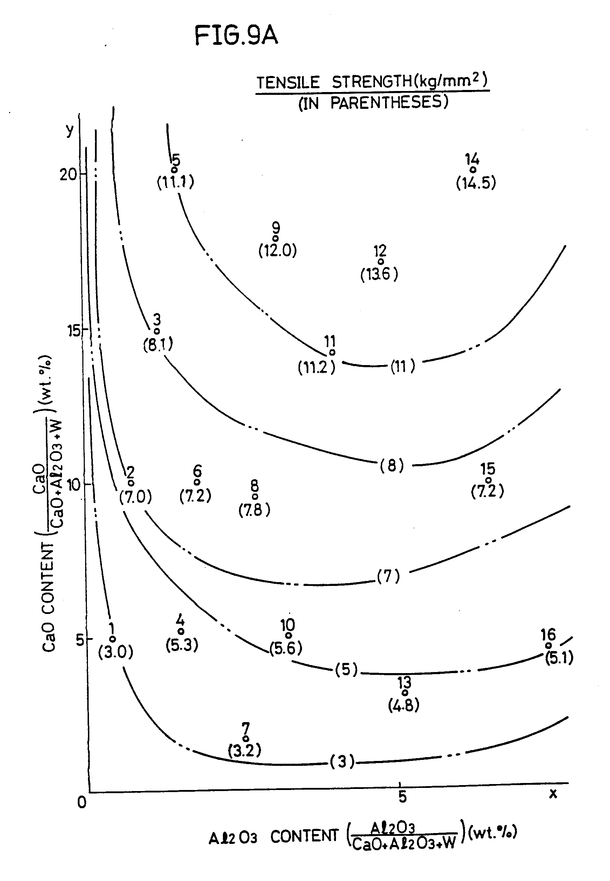

CaO powder and $Al_2O_3$ powder were added to tungsten powder in each ratio as shown in Table 1 and kneaded with an organic binder as a vehicle to provide paste. Each paste thus obtained was coated on the surface of each sample prepared by an AlN sintered body and subjected to debinder processing, and thereafter fired in a nitrogen atmosphere at a temperature as shown in Table 1 for 30 minutes, to obtain a metallized layer. Nickel plating was performed on the metallized layer of each sample, whose tensile strength was then measured by a soldering method. Fig. 8 shows a method of measuring tensile strength. Referring to Fig. 8, nickel plating was performed on a prescribed surface part (2 mm by 2 mm) of a metallized layer 2 which was formed on the surface of an aluminum nitride sintered body 1, and thereafter a stainless wire 16, being subjected to nickel plating of 0.8 mm$\phi$, was soldered on the same by a brazing metal 9 such as silver solder. The stainless wire 16 was pulled in an arrow direction, to measure the tensile strength. Table 1 also shows the results of such measurement.

Reference example was prepared by samples fired in wet hydrogen or nitrogen and wet $H_2$-$N_2$ mixtured gas by employing paste similar to the above. Table 1 also shows results of measurement of tensile strength of the reference example.

Airtightness of the metallized layer in each sample was examined by an He detector. All of the samples fired in accordance with the present invention were excellent in airtightness, while the reference samples were extremely inferior in airtightness. Within reference example, the sample No. 5 of tungsten paste was fired in nitrogen, and the remaining samples were fired in wet hydrogen or nitrogen and wet $H_2$-$N_2$ mixtured gas.

It is obvious from Table 1 that the metallized layers formed according to the present invention were higher in junction strength, being evaluated in terms of tensile strength, than those of reference example.

## Table 1

W Paste

| Sample No. | Content (wt. %) | | Firing Temperature ($^oC$) | Tensile Strength ($kg/mm^2$) |
|---|---|---|---|---|
| | $Al_2O_3$ | CaO | | |
| 1 | 3 | 2 | 1710 | 4.3 |
| 2 | 4 | 3 | 1700 | 5.4 |
| 3 | 5 | 3 | 1710 | 6.2 |
| 4 | 5 | 5 | 1705 | 8.1 |
| 5 | 5 | 10 | 1710 | 11.2 |
| 6 | 10 | 5 | 1700 | 8.3 |
| 7 | 10 | 10 | 1710 | 9.4 |
| 8 | 10 | 15 | 1700 | 10.0 |
| 9 | 20 | 15 | 1710 | 6.1 |
| 10 | 25 | 18 | 1705 | 4.4 |
| Reference Example | | | | |
| 1 | 4 | 3 | 1705 | 1.1 |
| 2 | 5 | 5 | 1710 | 1.2 |
| 3 | 5 | 10 | 1700 | 1.4 |
| 4 | 10 | 10 | 1705 | 0.9 |
| 5 | 0 | 0 | 1715 | 0.6 |

Example 2

AlN sintered bodies having metallized layers were prepared similarly to Example 1, except for that CaO was replaced by $CaCO_3$ or $Ca(NO_3)_2$. The firing condition was one hour under a temperature of 1600°C. Table 2 shows results of tensile strength of the samples thus obtained measured similarly to Example 1. It is obvious from Table 2 that the metallized layers formed in accordance with the present invention were excellent in junction strength, similarly to Example 1. Further, the samples of Example 2 were also excellent in airtightness, which was measured similarly to Example 1.

8

Table 2

| W Paste | | | | |
|---|---|---|---|---|
| Sample No. | Content (wt. %) | | Firing Temperature ($^o$C) | Tensile Strength (kg/mm$^2$) |
| | Al$_2$O$_3$ | CaCO$_3$ | | |
| 1 | 3 | 5 | 1600 | 5.1 |
| 2 | 5 | 8 | 1600 | 7.0 |
| 3 | 6 | 12 | 1600 | 11.1 |
| 4 | 8 | 16 | 1600 | 11.8 |
| 5 | 21 | 17 | 1600 | 5.9 |
| 6 | 3 | 5 | 1600 | 8.4 |
| 7 | 5 | 10 | 1600 | 10.5 |
| 8 | 8 | 14 | 1600 | 10.0 |
| 9 | 15 | 18 | 1600 | 6.8 |
| 10 | 21 | 23 | 1600 | 5.5 |

Example 3

CaO powder and AIN powder were added to tungsten powder in each ratio as shown in Table 3 and kneaded with an organic binder as a vehicle to provide paste. Each paste thus obtained was coated on the surface of each sample prepared by an AIN sintered body and subjected to debinder processing, and thereafter fired in a nitrogen atmosphere at a temperature as shown in Table 3 for 60 minutes, to obtain a metallized layer. The metallized layer of each sample was subjected to nickel plating, and tensile strength thereof was measured similarly to Example 1. Table 3 shows the results of such measurement.

Reference example was prepared by samples fired in wet hydrogen or nitrogen and wet H$_2$-N$_2$ mixtured gas through employment of paste similar to the above. Table 3 also shows the results of tensile strength of each reference sample measured in a similar manner to the above.

Airtightness of each sample was examined by an He detector. All of the samples fired in accordance with the present invention were excellent in airtightness, while all of the reference samples were extremely inferior in airtightness.

It is obvious from Table 3 that all of the metallized layers formed in accordance with the present invention were higher in junction strength than the reference samples.

Within reference example, the sample No. 5 of tungsten paste was fired in nitrogen and the remaining samples were fired in wet hydrogen or nitrogen and wet H$_2$-N$_2$ mixtured gas.

Table 3

W Paste

| Sample No. | Content (wt. %) | | Firing Temperature ($^{o}$C) | Tensile Strength (kg/mm$^2$) |
|---|---|---|---|---|
| | AlN | CaO | | |
| 1 | 1 | 1 | 1750 | 5.1 |
| 2 | 3 | 3 | 1750 | 6.2 |
| 3 | 5 | 3 | 1750 | 5.9 |
| 4 | 7 | 7 | 1750 | 7.8 |
| 5 | 10 | 7 | 1750 | 7.5 |
| 6 | 10 | 10 | 1750 | 9.3 |
| 7 | 10 | 14 | 1750 | 10.0 |
| 8 | 15 | 15 | 1750 | 9.2 |
| 9 | 20 | 15 | 1750 | 5.8 |
| 10 | 24 | 16 | 1750 | 4.2 |
| Reference Example | | | | |
| 1 | 1 | 1 | 1750 | 1.2 |
| 2 | 10 | 10 | 1750 | 1.4 |
| 3 | 20 | 15 | 1750 | 1.5 |
| 4 | 0 | 0 | 1750 | 1.3 |
| 5 | 0 | 0 | 1750 | 1.2 |

Example 4

AlN sintered bodies having metallized layers were prepared similarly to Example 3, except for that CaO was replaced by CaCO$_3$ or Ca(NO$_3$)$_2$. The firing condition was 120 minutes under a temperature of 1700°C. Table 4 shows tensile strength of each sample thus obtained, which was measured similarly to Example 1. It is obvious from Table 4 that all of the metallized layers formed in accordance with the present invention were excellent in junction strength. The samples of Example 4 were also excellent in airtightness, which was measured in a similar manner to Example 3.

10

## Table 4

W Paste

| Sample No. | Content (wt. %) | | Firing Temperature ($^{\circ}$C) | Tensile Strength (kg/mm$^2$) |
|---|---|---|---|---|
| | AlN | CaO | | |
| 1 | 3 | 5 | 1700 | 8.3 |
| 2 | 5 | 5 | 1700 | 6.4 |
| 3 | 7 | 12 | 1700 | 10.0 |
| 4 | 10 | 16 | 1700 | 10.5 |
| 5 | 23 | 17 | 1700 | 6.3 |
| | AlN | $Ca(NO_3)_2$ | | |
| 6 | 1 | 4 | 1700 | 6.3 |
| 7 | 6 | 10 | 1700 | 9.1 |
| 8 | 10 | 15 | 1700 | 9.9 |
| 9 | 10 | 16 | 1700 | 10.0 |
| 10 | 15 | 18 | 1700 | 7.4 |
| 11 | 23 | 20 | 1700 | 5.1 |

Example 5

CaO powder and $Al_2O_3$ powder were added to tungsten powder in each ratio as shown in Table 5 and kneaded with an organic binder such as vehicle to provide paste. Each content (wt.%) is shown in the ratio of tungsten (wt.%) + CaO (wt.%) + $Al_2O_3$ (wt.%) = 100 (wt.%). Each paste thus obtained was coated on the surface of each sample prepared by an AlN sintered body and subjected to debinder processing, and thereafter fired in a nitrogen atmosphere at a temperature of 1600°C for 60 minutes, to obtain a metallized layer.

The metallized layer of each sample was subjected to nickel plating of 2 to 3 $\mu$m in thickness and further subjected to gold plating of 2 to 3 $\mu$m in thickness, and thereafter heat treatment was performed in the atmosphere at a temperature of 450°C for 10 minutes, to examine the status of tarnishing and foaming on the plating surface. Table 5 shows the results. Further, appearance inspection was performed by a stereomicroscope of forty magnifications. Symbol A in Table 5 indicates those whose plating surfaces were recognized to be tarnished or foamed in the ratio of 0 to 5 % within 100 samples, symbol B indicates those in the ratio of 5 to 10 % and symbol C indicates those in the ratio of at least 10 %.

Further, nickel plating was performed in a part of each sample formed with a metallized layer in a prescribed area of 2 mm by 2 mm, and tensile strength was measured similarly to Example 1. Table 5 also shows the results of such measurement.

A metallized layer of each composition as shown in Table 5 was formed on the surface of each sample prepared by an AlN sintered body having a prescribed configuration, and a nickel plating layer of 2 to 3 $\mu$m in thickness and a gold plating layer of 2 to 3 $\mu$m in thickness were formed on the same. Thereafter a field-effect high-power transistor was soldered/carried on the surface of the plating layer by a brazing filler metal of Au-Si. A$\Delta V_{BE}$ method was performed to measure change $\Delta V_{BE}$ in forward voltage drop $V_{BE}$ across the emitter and the base of the transistor caused by electric power application, thereby to evaluate the thermal

11

resistance of the integrated transistor and AIN sintered body. Table 5 also shows the thermal resistance value of each sample.

Tensile strength and thermal resistance values of each sample are shown by average values of 10 and 5 measured values respectively.

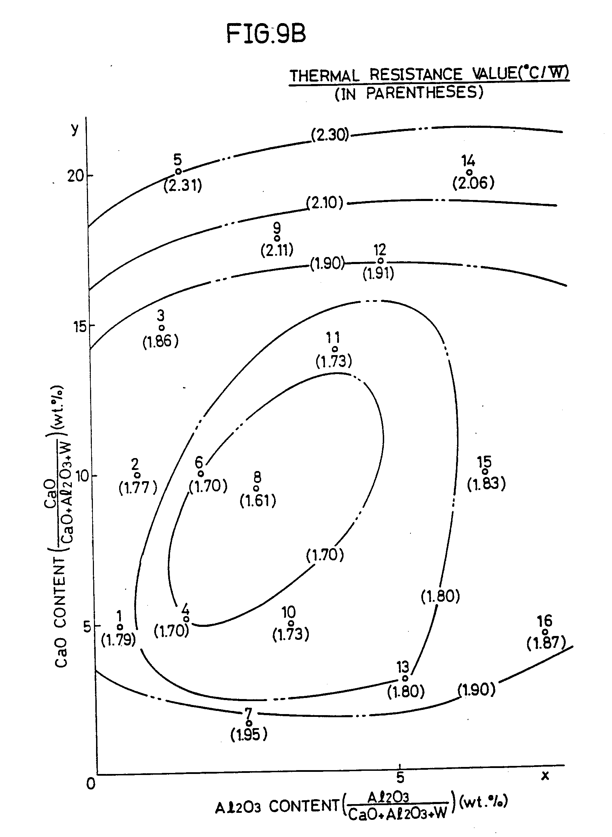

Fig. 9A illustrates tensile strength of the metallized layer of each sample obtained in Example 5, in terms of relation to contents of $Al_2O_3$ and CaO. The respective contents (wt.%) are shown in coordinate systems of (x, y) = ($Al_2O_3$ content, CaO content). Fig. 9B illustrates thermal resistance of each sample integrated with the transistor obtained in Example 5, in terms of relation to contents of $Al_2O_3$ and CaO. Referring to Figs. 9A and 9B, numeric values in parentheses represent tensile strength and thermal resistance values respectively.

According to Table 5, each metallized layer containing 1 to 5 percent by weight of aluminum oxide and 1 to 15 percent by weight of calcium oxide had a small degree of tarnishing frequency of gold plating. It is recognized that the plating layer formed on the metallized layer was particularly excellent in adhesive property with the contents of such ranges. Further, it is recognized from Fig. 9A that each metallized layer containing 1 to 10 percent by weight of aluminum oxide and 10 to 20 percent by weight of calcium oxide had junction strength, being evaluated as tensile strength, of at least around 7 Kg/mm$^2$, to implement an aluminum nitride sintered body which is preferably applied to a part of a package substrate for a semiconductor device. According to Fig. 9B, further, it is recognized that each AIN sintered body, being integrated with a transistor, having a metallized layer containing 1 to 10 percent by weight of aluminum oxide and 3 to 15 percent by weight of calcium oxide had a thermal resistance value of not more than about 1.9°C/W, to implement an AIN sintered body which is suitable for forming a part of a heat sink for a semiconductor device.

Reference example was formed by firing tungsten paste materials independently containing 7 percent by weight of borosilicate glass, 15 percent by weight of CaO and 8 percent by weight of $Al_2O_3$ respectively as assistants in a nitrogen atmosphere and a wet atmosphere similarly to Example 5. Tensile strength of each metallized layer thus obtained was unmeasurable and by far removed from a practical level. Further, paste identical in composition to that of Example 5 was fired in a wet atmosphere. Thermal resistance of an AIN sintered body having the metallized layer thus obtained was in excess of 2.5°C/W through measurement in a similar manner to the above.

Table 5

| W Paste | | | | | |
|---|---|---|---|---|---|
| Sample No. | Content (wt.%) | | Tensile Strength (kg/mm$^2$) | Thermal Resistance (°C/W) | Tarnishing Frequency of Au Plating |
| | $Al_2O_3$ | CaO | | | |
| 1 | 0.4 | 5.0 | 3.0 | 1.79 | A |
| 2 | 0.75 | 10.0 | 7.0 | 1.77 | A |
| 3 | 1.2 | 14.9 | 8.1 | 1.86 | A |
| 4 | 1.5 | 5.2 | 5.3 | 1.70 | A |
| 5 | 1.5 | 20.1 | 11.1 | 2.31 | C |
| 6 | 1.8 | 10.0 | 7.2 | 1.70 | A |
| 7 | 2.5 | 1.7 | 3.2 | 1.95 | A |
| 8 | 2.7 | 9.5 | 7.8 | 1.61 | A |
| 9 | 3.1 | 17.8 | 12.0 | 2.11 | B |
| 10 | 3.2 | 5.0 | 5.6 | 1.73 | A |
| 11 | 4.0 | 14.1 | 11.2 | 1.73 | A |
| 12 | 4.8 | 17.0 | 13.6 | 1.91 | B |
| 13 | 5.1 | 3.1 | 4.8 | 1.80 | B |
| 14 | 6.3 | 19.9 | 14.5 | 2.06 | C |
| 15 | 6.5 | 9.9 | 7.2 | 1.83 | B |
| 16 | 7.4 | 4.5 | 5.1 | 1.87 | B |

Example 6

Similarly to Example 5, CaO powder and $Al_2O_3$ powder were added to molybdenum powder in each ratio as shown in Table 6 and kneaded with an organic binder such as vehicle, to provide paste. The content (wt.%) of each paste was adjusted to satisfy the condition of molybdenum (wt.%) + CaO (wt.%) + $Al_2O_3$ (wt.%) = 100 (wt.%). Each paste thus obtained was coated on the surface of each sample prepared by an AIN sintered body and subjected to debinder processing, and thereafter fired in a nitrogen atmosphere at a temperature of 1550°C for 30 minutes, to obtain a metallized layer.

A nickel plating layer of 2 to 3 $\mu$m in thickness and a gold plating layer of 2 to 3 $\mu$m in thickness were formed on the metallized layer of each sample, which was then subjected to heat treatment in the atmosphere at a temperature of 450°C for 10 minutes, to examine the status of tarnishing and foaming on the plating surface. Table 6 shows the results of such examination, similarly to Example 5.

Table 6 also shows the result of measurement of tensile strength of each sample, similarly to Example 5.

Further, processing similar to that in Example 5 was performed on each sample, to evaluate thermal resistance of the AIN sintered body integrated with a transistor. Table 6 also shows the result of measurement of thermal resistance with respect to each sample.

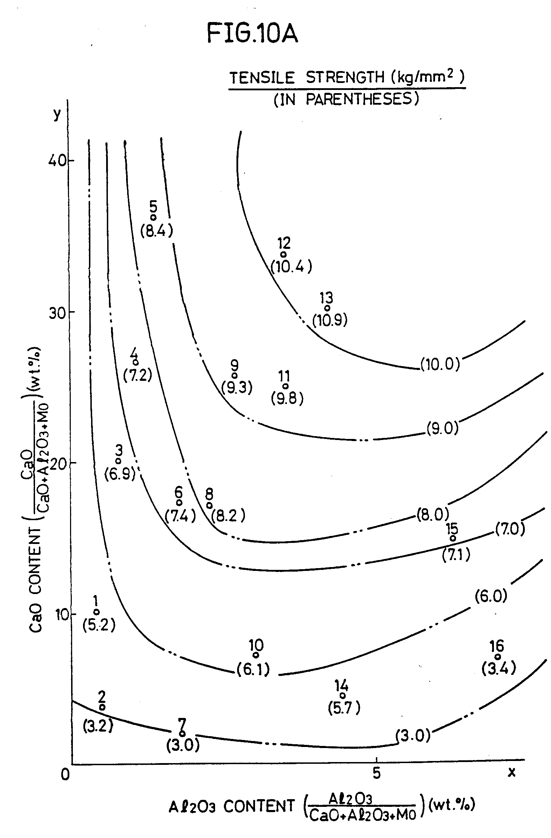

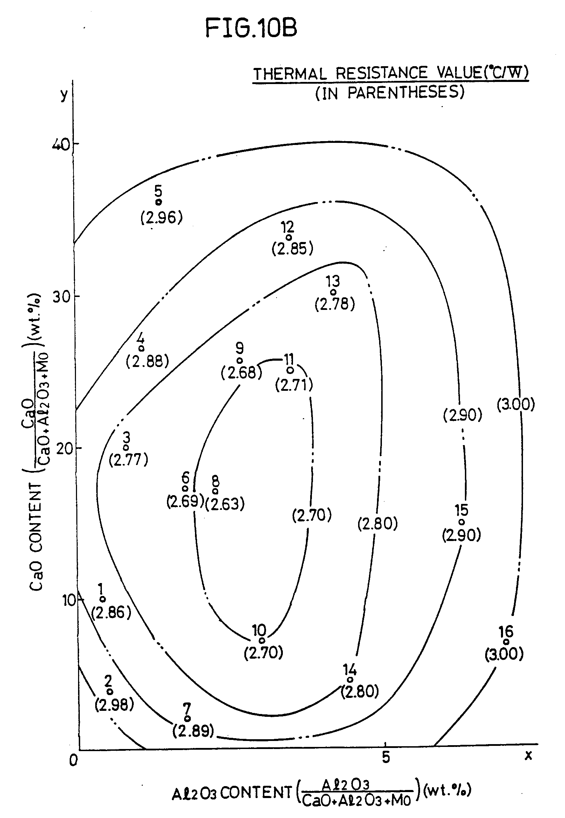

Tensile strength is shown in an average value of 10 measured values per sample, and thermal resistance is shown as an average value of five measured values per sample. Fig. 10A illustrates measured values of tensile strength thus obtained in terms of relation to contents of $Al_2O_3$ and CaO. Fig. 10B illustrates thermal resistance values in terms of relation to the contents of $Al_2O_3$ and CaO. Numeric values in the parentheses show tensile strength values and thermal resistance values in Figs. 10A and 10B respectively.

It is obvious from Table 6 that each metallized layer containing 1 to 5 percent by weight of aluminum oxide and 1 to 25 percent by weight of calcium oxide had small tarnishing frequency of gold plating, and was excellent in plating adhesive property. According to Fig. 10A, each metallized layer containing 1 to 10 percent by weight of aluminum oxide and 15 to 35 percent by weight of calcium oxide shows junction strength, being evaluated as tensile strength, of at least about 7 Kg/mm$^2$, to implement an AIN sintered body which is preferably applied to a part of a substrate of a package for a semiconductor device requiring excellent junction strength. Further, according to Fig. 10B, each AIN sintered body having a metallized layer containing 1 to 7 percent by weight of aluminum oxide and 1 to 35 percent by weight of calcium oxide shows a thermal resistance value of not more than about 3.0°C/W in integration with a transistor, to implement an AIN sintered body which is preferably applied to a part requiring good thermal conductivity.

Reference example was formed by firing molybdenum paste materials independently containing 14 percent by weight of borosilicate glass, 18 percent by weight of CaO and 7 percent by weight of $Al_2O_3$ respectively as assistants in a nitrogen atmosphere and a wet atmosphere similarly to Example 6. Tensile strength of each metallized layer thus obtained was unmeasurable and by far different from a practical level. Further, paste being identical in composition to that in Example 6 was fired in a wet atmosphere to obtain a metallized layer. Thermal resistance of an AIN sintered body provided with this metallized layer was in excess of 3.5°C/W, as the result of measurement performed similarly to the above.

Table 6

| Mo Paste | | | | | |
|---|---|---|---|---|---|
| Sample No. | Content (wt. %) | | Tensile Strength (kg/mm$^2$) | Thermal Resistance ($^o$c/w) | Tarnishing Frequency of Au Plating |
| | Al$_2$O$_3$ | CaO | | | |
| 1 | 0.4 | 10.0 | 5.2 | 2.86 | A |
| 2 | 0.5 | 3.9 | 3.2 | 2.98 | A |
| 3 | 0.8 | 20.0 | 6.9 | 2.77 | A |
| 4 | 1.1 | 26.5 | 7.2 | 2.88 | B |
| 5 | 1.4 | 36.0 | 8.4 | 2.96 | C |
| 6 | 1.8 | 17.2 | 7.4 | 2.69 | A |
| 7 | 1.8 | 2.0 | 3.0 | 2.89 | A |
| 8 | 2.3 | 17.0 | 8.2 | 2.63 | A |
| 9 | 2.7 | 25.6 | 9.3 | 2.68 | A |
| 10 | 3.0 | 7.1 | 6.1 | 2.70 | A |
| 11 | 3.5 | 24.9 | 9.8 | 2.71 | A |
| 12 | 3.5 | 33.6 | 10.4 | 2.85 | C |
| 13 | 4.2 | 30.0 | 10.9 | 2.78 | B |
| 14 | 4.4 | 4.4 | 5.7 | 2.80 | A |
| 15 | 6.3 | 14.8 | 7.1 | 2.90 | B |
| 16 | 7.0 | 6.8 | 3.4 | 3.00 | B |

Example 7

Calcium nitrate powder and aluminum oxide powder were fully mixed in the ratio of 30 g to 5 g, and fired in the air at a temperature of 1350$^o$C for three hours. The fired substance thus obtained was a mixture of $xCaO.yAl_2O_3$ (x,y: an integer) and CaO, which was then pulverized by a ball mill. 30 percent by weight of the powder thus obtained was blended with 70 percent by weight of molybdenum powder, and an organic binder as vehicle was added to the same to provide a molybdenum paste. The molybdenum paste was screen-printed on the surface of an AIN sintered body in a pattern having an area of 2 mm by 2 mm, and then fired in a nitrogen atmosphere at each firing temperature as shown in Table 7 for 120 minutes. Nickel plating was performed on the surface of each metallized layer thus obtained, to measure tensile strength similarly to Example 1. After the nickel plating, gold plating was further performed and a field-effect high-power transistor was carried on the same similarly to Example 5, to measure thermal resistance. Table 7 shows the results of such measurement.

Table 7

| Mo Paste | | | |
|---|---|---|---|
| Sample No. | Firing Temperature ($^o$C) | Tensile Strength (kg/mm$^2$) | Thermal Resistance ($^o$C/W) |
| 1 | 1450 | 0.9 | 3.10 |
| 2 | 1500 | 3.8 | 1.74 |
| 3 | 1550 | 7.9 | 1.66 |
| 4 | 1600 | 8.1 | 1.62 |
| 5 | 1650 | 8.4 | 1.72 |
| 6 | 1700 | 6.4 | 1.88 |
| 7 | 1750 | 4.3 | 2.10 |

While each aluminum compound was prepared by aluminum oxide or aluminum nitride in the aforementioned Examples, a similar function/effect can be attained by employing aluminum oxynitride.

According to the present invention as hereinabove described, a metallized layer, which is strongly adhered to an aluminum nitride sintered body, can be obtained with high airtightness and excellent thermal conductivity. Further, according to the inventive manufacturing method, firing of metal paste coated on an aluminum nitride sintered body can be performed in an inert atmosphere.

Although the present invention has been described and illustrated in detail, it is clearly understood that the same is by way of illustration and example only and is not to be taken by way of limitation, the spirit and scope of the present invention being limited only by the terms of the appended claims.

**Claims**

**Claims for the following Contracting States : DE, GB**

1.  An aluminum nitride sintered body formed with a metallized layer on its surface,
    said metallized layer containing:
    at least a metal selected from tungsten and molybdenum;
    at least an aluminum compound selected from a group of aluminum nitride, aluminum oxide and aluminum oxynitride; and
    calcium oxide, provided that said metallized layer contains at least 3 % by weight of calcium oxide when said metal is tungsten and said aluminium compound is aluminium oxide

2.  An aluminum nitride sintered body in accordance with claim 1, wherein
    said metallized layer contains 40 to 98 percent by weight of said metal, 1 to 25 percent by weight of said aluminum compound and 1 to 35 percent by weight of calcium oxide.

3.  An aluminum nitride sintered body in accordance with claim 1, wherein
    said metal is tungsten and said aluminum compound is aluminum oxide,
    said metallized layer containing 1 to 10 percent by weight of aluminum oxide and 1 to 20 percent by weight of calcium oxide.

4.  An aluminum nitride sintered body in accordance with claim 1, wherein
    said metal is molybdenum and said aluminum compound is aluminum oxide,
    said metallized layer containing 1 to 10 percent by weight of aluminum oxide and 1 to 35 percent by weight of calcium oxide.

5.  An aluminum nitride sintered body in accordance with claim 1, wherein
    said metal is tungsten and said aluminum compound is aluminum oxide,
    said metallized layer containing 1 to 10 percent by weight of aluminum oxide and 10 to 20 percent by weight of calcium oxide.

6.  An aluminum nitride sintered body in accordance with claim 1, wherein
    said metal is tungsten and said aluminum compound is aluminum oxide,
    said metallized layer containing 1 to 10 percent by weight of aluminum oxide and 3 to 15 percent by weight of calcium oxide.

7.  An aluminum nitride sintered body in accordance with claim 1, wherein
    said metal is tungsten and said aluminum compound is aluminum oxide,
    said metallized layer containing 1 to 5 percent by weight of aluminum oxide and 1 to 15 percent by weight of calcium oxide.

8.  An aluminum nitride sintered body in accordance with claim 1, wherein
    said metal is molybdenum and said aluminum compound is aluminum oxide,
    said metallized layer containing 1 to 10 percent by weight of aluminum oxide and 15 to 35 percent by weight of calcium oxide.

9.  An aluminum nitride sintered body in accordance with claim 1, wherein
    said metal is molybdenum and said aluminum compound is aluminum oxide,
    said metallized layer containing 1 to 7 percent by weight of aluminum oxide and 1 to 35 percent by weight of calcium oxide.

10. An aluminum nitride sintered body in accordance with claim 1, wherein

said metal is molybdenum and sac aluminum compound is aluminum oxide,
said metallized layer containing 1 to 5 percent by weight of aluminum oxide and 1 to 25 percent by weight of calcium oxide.

**11.** An aluminum nitride sintered body in accordance with claim 1, being adapted to form a part of a substrate of a package for a semiconductor device.

**12.** An aluminum nitride sintered body in accordance with claim 11, wherein
said metal is tungsten and said aluminum compound is aluminum oxide,
said metallized layer containing 1 to 10 percent by weight of aluminum oxide and 10 to 20 percent by weight of calcium oxide.

**13.** An aluminum nitride sintered body in accordance with claim 11, wherein
said metal is molybdenum and said aluminum compound is aluminum oxide,
said metallized layer containing 1 to 10 percent by weight of aluminum oxide and 15 to 35 percent by weight of calcium oxide.

**14.** An aluminum nitride sintered body in accordance with claim 1, being adapted to form a part of a heat sink for a semiconductor device.

**15.** An aluminum nitride sintered body in accordance with claim 14, wherein
said metal is tungsten and said aluminum compound is aluminum oxide,
said metallized layer containing 1 to 10 percent by weight of aluminum oxide and 3 to 15 percent by weight of calcium oxide.

**16.** An aluminum nitride sintered body in accordance with claim 14, wherein
said metal is molybdenum and said aluminum compound is aluminum oxide,
said metallized layer containing 1 to 7 percent by weight of aluminum oxide and 1 to 35 percent by weight of calcium oxide.

**17.** An aluminum nitride sintered body in accordance with claim 1, being adapted to form a part of a cap for airtightly sealing a package for a semiconductor device.

**18.** A method of forming a metallized layer on the surface of an aluminum nitride sintered body, comprising:
a step of preparing an aluminum nitride sintered body previously fired to be in a prescribed configuration;
a step of providing metal paste of at least tungsten or molybdenum, said paste containing powder of at least a calcium compound selected from a group of calcium oxide, calcium nitrate and calcium carbonate, and powder of at least an aluminum compound selected from a group of aluminum nitride, aluminum oxide and aluminum oxynitride;
a step of coating said metal paste on the surface of said aluminum nitride sintered body; and
a step of firing said aluminum nitride sintered body coated with said metal paste in an inert atmosphere, provided that said metallized layer contains at least 3% by weight of calcium oxide when said metal component is tungsten and said aluminium compound is aluminium oxide.

**19.** A method of forming a metallized layer on the surface of an aluminum nitride sintered body in accordance with claim 18, wherein
said step of providing said metal paste includes kneading of said calcium compound powder, said aluminum compound powders and metal powder of at least tungsten or molybdenum.

**20.** A method of forming a metallized layer on the surface of an aluminum nitride sintered body in accordance with claim 18, wherein
said step of providing said metal paste includes:
a process of previously mixing said calcium compound powder and said aluminum compound powder and firing the same to provide a fired substance, and
a process of kneading powder of said fired substance with metal powder of at least tungsten or molybdenum to provide said metal paste.

EP 0 276 788 B1

**Claims for the following Contracting States : FR, IT**

1. An aluminum nitride sintered body formed with a metallized layer on its surface, said metallized layer containing: at least a metal selected from tungsten and molybdenum; at least an aluminum compound selected from a group of aluminum nitride, aluminum oxide and aluminum oxynitride; and calcium oxide.

2. An aluminum nitride sintered body in accordance with claim 1, wherein said metallized layer contains 40 to 98 percent by weight of said metal, 1 to 25 percent by weight of said aluminum compound and 1 to 35 percent by weight of calcium oxide.

3. An aluminum nitride sintered body in accordance with claim 1, wherein said metal is tungsten and said aluminum compound is aluminum oxide, said metallized layer containing 1 to 10 percent by weight of aluminum oxide and 1 to 20 percent by weight of calcium oxide.

4. An aluminum nitride sintered body in accordance with claim 1, wherein said metal is molybdenum and said aluminum compound is aluminum oxide, said metallized layer containing 1 to 10 percent by weight of aluminum oxide and 1 to 35 percent by weight of calcium oxide.

5. An aluminum nitride sintered body in accordance with claim 1, wherein said metal is tungsten and said aluminum compound is aluminum oxide, said metallized layer containing 1 to 10 percent by weight of aluminum oxide and 10 to 20 percent by weight of calcium oxide.

6. An aluminum nitride sintered body in accordance with claim 1, wherein said metal is tungsten and said aluminum compound is aluminum oxide, said metallized layer containing 1 to 10 percent by weight of aluminum oxide and 3 to 15 percent by weight of calcium oxide.

7. An aluminum nitride sintered body in accordance with claim 1, wherein said metal is tungsten and said aluminum compound is aluminum oxide, said metallized layer containing 1 to 5 percent by weight of aluminum oxide and 1 to 15 percent by weight of calcium oxide.

8. An aluminum nitride sintered body in accordance with claim 1, wherein said metal is molybdenum and said aluminum compound is aluminum oxide, said metallized layer containing 1 to 10 percent by weight of aluminum oxide and 15 to 35 percent by weight of calcium oxide.

9. An aluminum nitride sintered body in accordance with claim 1, wherein said metal is molybdenum and said aluminum compound is aluminum oxide, said metallized layer containing 1 to 7 percent by weight of aluminum oxide and 1 to 35 percent by weight of calcium oxide.

10. An aluminum nitride sintered body in accordance with claim 1, wherein said metal is molybdenum and said aluminum compound is aluminum oxide, said metallized layer containing 1 to 5 percent by weight of aluminum oxide and 1 to 25 percent by weight of calcium oxide.

11. An aluminum nitride sintered body in accordance with claim 1, being adapted to form a part of a substrate of a package for a semiconductor device.

12. An aluminum nitride sintered body in accordance with claim 11, wherein said metal is tungsten and said aluminum compound is aluminum oxide,

17

EP 0 276 788 B1

said metallized layer containing 1 to 10 percent by weight of aluminum oxide and 10 to 20 percent by weight of calcium oxide.

13. An aluminum nitride sintered body in accordance with claim 11, wherein
said metal is molybdenum and said aluminum compound is aluminum oxide,
said metallized layer containing 1 to 10 percent by weight of aluminum oxide and 15 to 35 percent by weight of calcium oxide.

14. An aluminum nitride sintered body in accordance with claim 1, being adapted to form a part of a heat sink for a semiconductor device.

15. An aluminum nitride sintered body in accordance with claim 14, wherein
said metal is tungsten and said aluminum compound is aluminum oxide,
said metallized layer containing 1 to 10 percent by weight of aluminum oxide and 3 to 15 percent by weight of calcium oxide.

16. An aluminum nitride sintered body in accordance with claim 14, wherein
said metal is molybdenum and said aluminum compound is aluminum oxide,
said metallized layer containing 1 to 7 percent by weight of aluminum oxide and 1 to 35 percent by weight of calcium oxide.

17. An aluminum nitride sintered body in accordance with claim 1, being adapted to form a part of a cap for airtightly sealing a package for a semiconductor device.

18. A method of forming a metallized layer on the surface of an aluminum nitride sintered body, comprising:
a step of preparing an aluminum nitride sintered body previously fired to be in a prescribed configuration;
a step of providing metal paste of at least tungsten or molybdenum, said paste containing powder of at least a calcium compound selected from a group of calcium-oxide, calcium nitrate and calcium carbonate, and powder of at least an aluminum compound selected from a group of aluminum nitride, aluminum oxide and aluminum oxynitride;
a step of coating said metal paste on the surface of said aluminum nitride sintered body; and
a step of firing said aluminum nitride sintered body coated with said metal paste in an inert atmosphere.

19. A method of forming a metallized layer on the surface of an aluminum nitride sintered body in accordance with claim 18, wherein
said step of providing said metal paste includes kneading of said calcium compound powder, said aluminum compound powder and metal powder of at least tungsten or molybdenum.

20. A method of forming a metallized layer on the surface of an aluminum nitride sintered body in accordance with claim 18, wherein
said step of providing said metal paste includes:
a process of previously mixing said calcium compound powder and said aluminum compound powder and firing the same to provide a fired substance, and
a process of kneading powder of said fired substance with metal powder of at least tungsten or molybdenum to provide said metal paste.

**Patentansprüche**
**Patentansprüche für folgende Vertragsstaaten : DE, GB**

1. Gesinterter Aluminiumnitritkörper mit einer auf seiner Oberfläche gebildeten metallhaltigen Schicht, wobei die metallhaltige Schicht enthält:
- mindestens ein Metall, ausgewählt aus Wolfram und Molybdän;
- mindestens eine Aluminiumverbindung ausgewählt aus einer Gruppe aus Aluminiumnitrit, Aluminiumoxid und Aluminiumoxynitrit; und
- Kalziumoxid, vorausgesetzt, daß die metallhaltige Schicht mindestens 3 Gew.-% Kalziumoxid

18

enthält, wenn das Metall Wolfram und die Aluminiumverbindung Aluminiumoxid ist.

2.   Gesinterter Aluminiumnitritkörper nach Anspruch 1, wobei die metallhaltige Schicht 40 bis 98 Gew.-% des Metalls, 1 bis 25 Gew.-% der Aluminiumverbindung und 1 bis 35 Gew.-% Kalziumoxid enthält.

3.   Gesinterter Aluminiumnitritkörper nach Anspruch 1, wobei das Metall Wolfram und die Aluminiumverbindung Aluminiumoxid ist, und die metallhaltige Schicht 1 bis 10 Gew.-% Aluminiumoxid und 1 bis 20 Gew.-% Kalziumoxid enthält.

4.   Gesinterter Aluminiumnitritkörper nach Anspruch 1, wobei das Metall Molybdän und die Aluminiumverbindung Aluminiumoxid ist, und die metallhaltige Schicht 1 bis 10 Gew.-% Aluminiumoxid und 1 bis 35 Gew.-% Kalziumoxid enthält.

5.   Gesinterter Aluminiumnitritkörper nach Anspruch 1, wobei das Metall Wolfram und die Aluminiumverbindung Aluminiumoxid ist, und die metallhaltige Schicht 1 bis 10 Gew.-% Aluminiumoxid und 10 bis 20 Gew.-% Kalziumoxid enthält.

6.   Gesinterter Aluminiumnitritkörper nach Anspruch 1, wobei das Metall Wolfram und die Aluminiumverbindung Aluminiumoxid ist, und die metallhaltige Schicht 1 bis 10 Gew.-% Aluminiumoxid und 3 bis 15 Gew.-% Kalziumoxid enthält.

7.   Gesinterter Aluminiumnitritkörper nach Anspruch 1, wobei das Metall Wolfram und die Aluminiumverbindung Aluminiumoxid ist, und die metallhaltige Schicht 1 bis 5 Gew.-% Aluminiumoxid und 1 bis 15 Gew.-% Kalziumoxid enthält.

8.   Gesinterter Aluminiumnitritkörper nach Anspruch 1, wobei das Metall Molybdän und die Aluminiumverbindung Aluminiumoxid ist, und die metallhaltige Schicht 1 bis 10 Gew.-% Aluminiumoxid und 15 bis 35 Gew.-% Kalziumoxid enthält.

9.   Gesinterter Aluminiumnitritkörper nach Anspruch 1, wobei das Metall Molybdän und die Aluminiumverbindung Aluminiumoxid ist, und die metallhaltige Schicht 1 bis 7 Gew.-% Aluminiumoxid und 1 bis 35 Gew.-% Kalziumoxid enthält.

10.   Gesinterter Aluminiumnitritkörper nach Anspruch 1, wobei das Metall Wolfram und die Aluminiumverbindung Aluminiumoxid ist, und die metallhaltige Schicht 1 bis 5 Gew.-% Aluminiumoxid und 1 bis 25 Gew.-% Kalziumoxid enthält.

11.   Gesinterter Aluminiumnitritkörper nach Anspruch 1, der geeignet ist, einen Teil eines Substrats eines Blocks für ein Halbleiterbauteil zu bilden.

12.   Gesinterter Aluminiumnitritkörper nach Anspruch 11, wobei das Metall Wolfram und die Aluminiumverbindung Aluminiumoxid ist, und die metallhaltige Schicht 1 bis 10 Gew.-% Aluminiumoxid und 10 bis 20 Gew.-% Kalziumoxid enthält.

13.   Gesinterter Aluminiumnitritkörper nach Anspruch 11, wobei das Metall Molybdän und die Aluminiumverbindung Aluminiumoxid ist, und die metallhaltige Schicht 1 bis 10 Gew.-% Aluminiumoxid und 15 bis 35 Gew.-% Kalziumoxid enthält.

14.   Gesinterter Aluminiumnitritkörper nach Anspruch 1, der geeignet ist, einen Teil einer Hitzesenke für ein Halbleiterbauteil zu bilden.

15.   Gesinterter Aluminiumnitritkörper nach Anspruch 14, wobei das Metall Wolfram und die Aluminiumverbindung Aluminiumoxid ist, und die metallhaltige Schicht 1 bis 10 Gew.-% Aluminiumoxid und 3 bis 15 Gew.-% Kalziumoxid enthält.

16.   Gesinterter Aluminiumnitritkörper nach Anspruch 11, wobei das Metall Molybdän und die Aluminiumverbindung Aluminiumoxid ist, und die metallhaltige Schicht 1 bis 7 Gew.-% Aluminiumoxid und 1 bis 35 Gew.-% Kalziumoxid enthält.

**17.** Gesinterter Aluminiumnitritkörper nach Anspruch 1, der geeignet ist, einen Teil einer Hülle zum luftundurchlässigen Abdichten eines Blocks für ein Halbleiterbauteil zu bilden.

**18.** Verfahren zur Herstellung einer metallhaltigen Schicht auf der Oberfläche eines gesinterten Aluminiumnitritkörpers, das folgende Schritte umfaßt:
- einen Schritt zur Herstellung eines gesinterten Aluminiumnitritkörpers, der vorher gebrannt wurde, um in einer vorgeschriebenen Gestalt zu sein;
- einen Schritt zur Herstellung einer Metallpaste aus mindestens Wolfram oder Molybdän, wobei die Paste ein Pulver mindestens einer Kalziumverbindung, die aus einer Gruppe aus Kalziumoxid, Kalziumnitrat und Kalziumkarbonat ausgewählt ist, und ein Pulver mindestens einer Aluminiumverbindung, die aus einer Gruppe aus Aluminiumnitrit, Aluminiumoxid und Aluminiumoxynitrit ausgewählt ist, enthält;
- einen Schritt zur Beschichtung der Metallpaste auf der Oberfläche des gesinterten Aluminiumnitritkörpers; und
- einen Schritt zum Brennen des gesinterten Aluminiumnitritkörpers, der mit der Metallpaste beschichtet ist, in einer inerten Atmosphäre, vorausgesetzt, daß die metallhaltige Schicht mindestens 3 Gew.-% Kalziumoxid enthält, wenn die Metall-Komponente Wolfram ist und die Aluminiumverbindung Aluminiumoxid ist.

**19.** Verfahren zur Herstellung einer metallhaltigen Schicht auf der Oberfläche eines gesinterten Aluminiumnitritkörpers nach Anspruch 18, wobei der Schritt zur Herstellung der Metallpaste das Kneten des Pulvers der Kalziumverbindung, des Pulvers der Aluminiumverbindung und des Metallpulvers von mindestens Wolfram oder Molybdän umfaßt.

**20.** Verfahren zur Herstellung einer metallhaltigen Schicht auf der Oberfläche eines gesinterten Aluminiumnitritkörpers nach Anspruch 18, wobei der Schritt zur Herstellung der Metallpaste umfaßt:
- ein Verfahren des vorherigen Mischens des Pulvers der Kalziumverbindung und des Pulvers der Aluminiumverbindung und des Brennens desselben, um eine gebrannte Substanz herzustellen, und
- ein Verfahren des Knetens des Pulvers, der gebrannten Substanz, mit Metallpulver aus mindestens Wolfram oder Molybdän, um die Metallpaste herzustellen.

**Patentansprüche für folgende Vertragsstaaten : FR, IT**

**1.** Gesinterter Aluminiumnitritkörper mit einer auf seiner Oberfläche gebildeten metallhaltigen Schicht, wobei die metallhaltige Schicht enthält:
- mindestens ein Metall, ausgewählt aus Wolfram und Molybdän;
- mindestens eine Aluminiumverbindung ausgewählt aus einer Gruppe aus Aluminiumnitrit, Aluminiumoxid und Aluminiumoxynitrit; und
- Kalziumoxid.

**2.** Gesinterter Aluminiumnitritkörper nach Anspruch 1, wobei die metallhaltige Schicht 40 bis 98 Gew.-% des Metalls, 1 bis 25 Gew.-% der Aluminiumverbindung und 1 bis 35 Gew.-% Kalziumoxid enthält.

**3.** Gesinterter Aluminiumnitritkörper nach Anspruch 1, wobei das Metall Wolfram und die Aluminiumverbindung Aluminiumoxid ist, und die metallhaltige Schicht 1 bis 10 Gew.-% Aluminiumoxid und 1 bis 20 Gew.-% Kalziumoxid enthält.

**4.** Gesinterter Aluminiumnitritkörper nach Anspruch 1, wobei das Metall Molybdän und die Aluminiumverbindung Aluminiumoxid ist, und die metallhaltige Schicht 1 bis 10 Gew.-% Aluminiumoxid und 1 bis 35 Gew.-% Kalziumoxid enthält.

**5.** Gesinterter Aluminiumnitritkörper nach Anspruch 1, wobei das Metall Wolfram und die Aluminiumverbindung Aluminiumoxid ist, und die metallhaltige Schicht 1 bis 10 Gew.-% Aluminiumoxid und 10 bis 20 Gew.-% Kalziumoxid enthält.

**6.** Gesinterter Aluminiumnitritkörper nach Anspruch 1, wobei das Metall Wolfram und die Aluminiumverbindung Aluminiumoxid ist, und die metallhaltige Schicht 1 bis 10 Gew.-% Aluminiumoxid und 3 bis 15 Gew.-% Kalziumoxid enthält.

7. Gesinterter Aluminiumnitritkörper nach Anspruch 1, wobei das Metall Wolfram und die Aluminiumverbindung Aluminiumoxid ist, und die metallhaltige Schicht 1 bis 5 Gew.-% Aluminiumoxid und 1 bis 15 Gew.-% Kalziumoxid enthält.

8. Gesinterter Aluminiumnitritkörper nach Anspruch 1, wobei das Metall Molybdän und die Aluminiumverbindung Aluminiumoxid ist, und die metallhaltige Schicht 1 bis 10 Gew.-% Aluminiumoxid und 15 bis 35 Gew.-% Kalziumoxid enthält.

9. Gesinterter Aluminiumnitritkörper nach Anspruch 1, wobei das Metall Molybdän und die Aluminiumverbindung Aluminiumoxid ist, und die metallhaltige Schicht 1 bis 7 Gew.-% Aluminiumoxid und 1 bis 35 Gew.-% Kalziumoxid enthält.

10. Gesinterter Aluminiumnitritkörper nach Anspruch 1, wobei das Metall Wolfram und die Aluminiumverbindung Aluminiumoxid ist, und die metallhaltige Schicht 1 bis 5 Gew.-% Aluminiumoxid und 1 bis 25 Gew.-% Kalziumoxid enthält.

11. Gesinterter Aluminiumnitritkörper nach Anspruch 1, der geeignet ist, einen Teil eines Substrats eines Blocks für ein Halbleiterbauteil zu bilden.

12. Gesinterter Aluminiumnitritkörper nach Anspruch 11, wobei das Metall Wolfram und die Aluminiumverbindung Aluminiumoxid ist, und die metallhaltige Schicht 1 bis 10 Gew.-% Aluminiumoxid und 10 bis 20 Gew.-% Kalziumoxid enthält.

13. Gesinterter Aluminiumnitritkörper nach Anspruch 11, wobei das Metall Molybdän und die Aluminiumverbindung Aluminiumoxid ist, und die metallhaltige Schicht 1 bis 10 Gew.-% Aluminiumoxid und 15 bis 35 Gew.-% Kalziumoxid enthält.

14. Gesinterter Aluminiumnitritkörper nach Anspruch 1, der geeignet ist, einen Teil einer Hitzesenke für ein Halbleiterbauteil zu bilden.

15. Gesinterter Aluminiumnitritkörper nach Anspruch 14, wobei das Metall Wolfram und die Aluminiumverbindung Aluminiumoxid ist, und die metallhaltige Schicht 1 bis 10 Gew.-% Aluminiumoxid und 3 bis 15 Gew.-% Kalziumoxid enthält.

16. Gesinterter Aluminiumnitritkörper nach Anspruch 11, wobei das Metall Molybdän und die Aluminiumverbindung Aluminiumoxid ist, und die metallhaltige Schicht 1 bis 7 Gew.-% Aluminiumoxid und 1 bis 35 Gew.-% Kalziumoxid enthält.

17. Gesinterter Aluminiumnitritkörper nach Anspruch 1, der geeignet ist, einen Teil einer Hülle zum luftundurchlässigen Abdichten eines Blocks für ein Halbleiterbauteil zu bilden.

18. Verfahren zur Herstellung einer metallhaltigen Schicht auf der Oberfläche eines gesinterten Aluminiumnitritkörpers, das folgende Schritte umfaßt:
   - einen Schritt zur Herstellung eines gesinterten Aluminiumnitritkörpers, der vorher gebrannt wurde, um in einer vorgeschriebenen Gestalt zu sein;
   - einen Schritt zur Herstellung einer Metallpaste aus mindestens Wolfram oder Molybdän, wobei die Paste ein Pulver mindestens einer Kalziumverbindung` die aus einer Gruppe aus Kalziumoxid, Kalziumnitrat und Kalziumkarbonat ausgewählt ist, und ein Pulver mindestens einer Aluminiumverbindung` die aus einer Gruppe aus Aluminiumnitrit, Aluminiumoxid und Aluminiumoxynitrit ausgewählt ist, enthält;
   - einen Schritt zur Beschichtung der Metallpaste auf der Oberfläche des gesinterten Aluminiumnitritkörpers; und
   - einen Schritt zum Brennen des gesinterten Aluminiumnitritkörpers, der mit der Metallpaste beschichtet ist, in einer inerten Atmosphäre.

19. Verfahren zur Herstellung einer metallhaltigen Schicht auf der Oberfläche eines gesinterten Aluminium-

21

EP 0 276 788 B1

nitritkörpers nach Anspruch 18, wobei der Schritt zur Herstellung der Metallpaste das Kneten des Pulvers der Kalziumverbindung, des Pulvers der Aluminiumverbindung und des Metallpulvers von mindestens Wolfram oder Molybdän umfaßt.

20. Verfahren zur Herstellung einer metallhaltigen Schicht auf der Oberfläche eines gesinterten Aluminiumnitritkörpers nach Anspruch 18, wobei der Schritt zur Herstellung der Metallpaste umfaßt:
- ein Verfahren des vorherigen Mischens des Pulvers der Kalziumverbindung und des Pulvers der Aluminiumverbindung und des Brennens desselben, um eine gebrannte Substanz herzustellen, und
- ein Verfahren des Knetens des Pulvers, der gebrannten Substanz, mit Metallpulver aus mindestens Wolfram oder Molybdän, um die Metallpaste herzustellen.

**Revendications**
**Revendications pour les Etats contractants suivants : DE, GB**

1. Un corps fritté en nitrure d'aluminium ayant une couche métallisée sur sa surface,
   ladite couche métallisée contenant :
   au moins un métal choisi parmi le tungstène et le molybdène ;
   au moins un composé d'aluminium choisi parmi le nitrure d'aluminium, l'oxyde d'aluminium et l'oxynitrure d'aluminium ; et
   de l'oxyde de calcium,
   sous réserve que ladite couche métallisée contienne au moins 3 % en poids d'oxyde de calcium lorsque ledit métal est le tungstène et ledit composé d'aluminium est l'oxyde d'aluminium.

2. Un corps fritté en nitrure d'aluminium selon la revendication 1, dans lequel
   ladite couche métallisée contient 40 à 98 % en poids dudit métal, 1 à 25 % en poids dudit composé d'aluminium et 1 à 35 % en poids d'oxyde de calcium.

3. Un corps fritté en nitrure d'aluminium selon la revendication 1, dans lequel
   ledit métal est le tungstène et ledit composé d'aluminium est l'oxyde d'aluminium,
   ladite couche métallisée contenant 1 à 10 % en poids d'oxyde d'aluminium et 1 à 20 % en poids d'oxyde de calcium.

4. Un corps fritté en nitrure d'aluminium selon la revendication 1, dans lequel
   ledit métal est le molybdène et ledit composé d'aluminium est l'oxyde d'aluminium,
   ladite couche métallisée contenant 1 à 10 % en poids d'oxyde d'aluminium et 1 à 35 % en poids d'oxyde de calcium.

5. Un corps fritté en nitrure d'aluminium selon la revendication 1, dans lequel
   ledit métal est le tungstène et ledit composé d'aluminium est l'oxyde d'aluminium,
   ladite couche métallisée contenant 1 à 10 % en poids d'oxyde d'aluminium et 10 à 20 % en poids d'oxyde de calcium.

6. Un corps fritté en nitrure d'aluminium selon la revendication 1, dans lequel
   ledit métal est le tungstène et ledit composé d'aluminium est l'oxyde d'aluminium,
   ladite couche métallisée contenant 1 à 10 % en poids d'oxyde d'aluminium et 3 à 15 % en poids d'oxyde de calcium.

7. Un corps fritté en nitrure d'aluminium selon la revendication 1, dans lequel
   ledit métal est le tungstène et ledit composé d'aluminium est l'oxyde d'aluminium,
   ladite couche métallisée contenant 1 à 5 % en poids d'oxyde d'aluminium et 1 à 15 % en poids d'oxyde de calcium.

8. Un corps fritté en nitrure d'aluminium selon la revendication 1, dans lequel
   ledit métal est le molybdène et ledit composé d'aluminium est l'oxyde d'aluminium,
   ladite couche métallisée contenant 1 à 10 % en poids d'oxyde d'aluminium et 15 à 35 % en poids d'oxyde de calcium.

22

**9.** Un corps fritté en nitrure d'aluminium selon la revendication 1, dans lequel
ledit métal est le molybdène et ledit composé d'aluminium est l'oxyde d'aluminium,
ladite couche métallisée contenant 1 à 7 % en poids d'oxyde d'aluminium et 1 à 35 % en poids
d'oxyde de calcium.

**10.** Un corps fritté en nitrure d'aluminium selon la revendication 1, dans lequel
ledit métal est le molybdène et ledit composé d'aluminium est l'oxyde d'aluminium,
ladite couche métallisée contenant 1 à 5 % en poids d'oxyde d'aluminium et 1 à 25 % en poids
d'oxyde de calcium.

**11.** Un corps fritté en nitrure d'aluminium selon la revendication 1 conçu pour former une partie d'un
substrat d'un boîtier pour un dispositif semi-conducteur.

**12.** Un corps fritté en nitrure d'aluminium selon la revendication 11, dans lequel
ledit métal est le tungstène et ledit composé d'aluminium est l'oxyde d'aluminium,
ladite couche métallisée contenant 1 à 10 % en poids d'oxyde d'aluminium et 10 à 20 % en poids
d'oxyde de calcium.

**13.** Un corps fritté en nitrure d'aluminium selon la revendication 11, dans lequel
ledit métal est le molybdène et ledit composé d'aluminium est l'oxyde d'aluminium,
ladite couche métallisée contenant 1 à 10 % en poids d'oxyde d'aluminium et 15 à 35 % en poids
d'oxyde de calcium.

**14.** Un corps fritté en nitrure d'aluminium selon la revendication 1 conçu pour former une partie d'un
refroidisseur d'un dispositif semi-conducteur.

**15.** Un corps fritté en nitrure d'aluminium selon la revendication 14, dans lequel
ledit métal est le tungstène et ledit composé d'aluminium est l'oxyde d'aluminium,
ladite couche métallisée contenant 1 à 10 % en poids d'oxyde d'aluminium et 3 à 15 % en poids
d'oxyde de calcium.

**16.** Un corps fritté en nitrure d'aluminium selon la revendication 14, dans lequel
ledit métal est le molybdène et ledit composé d'aluminium est l'oxyde d'aluminium,
ladite couche métallisée contenant 1 à 7 % en poids d'oxyde d'aluminium et 1 à 35 % en poids
d'oxyde de calcium.

**17.** Un corps fritté en nitrure d'aluminium selon la revendication 1 conçu pour former une partie d'un
capuchon pour assurer l'étanchéité à l'air d'un boîtier pour un dispositif semi-conducteur.

**18.** Un procédé pour former une couche métallisée sur la surface d'un corps fritté en nitrure d'aluminium
comprenant :
une étape de préparation d'un corps fritté en nitrure d'aluminium préalablement cuit pour qu'il ait
une configuration déterminée ;
une étape d'obtention d'une pâte métallique au moins de tungstène ou de molybdène, ladite pâte
contenant une poudre d'au moins un composé du calcium, choisi parmi l'oxyde de calcium, le nitrate
de calcium et le carbonate de calcium, et une poudre d'au moins un composé d'aluminium, choisi
parmi le nitrure d'aluminium, l'oxyde d'aluminium et l'oxynitrure d'aluminium ;
une étape de revêtement de la surface dudit corps fritté en nitrure d'aluminium avec ladite pâte
métallique ; et
une étape de cuisson dudit corps fritté en nitrure d'aluminium revêtu de ladite pâte métallique dans
une atmosphère inerte, sous réserve que ladite couche métallisée contienne au moins 3 % en poids
d'oxyde de calcium lorsque ledit composant métallique est le tungstène et ledit composé d'aluminium
est l'oxyde d'aluminium.

**19.** Un procédé pour former une couche métallisée sur la surface d'un corps fritté en nitrure d'aluminium
selon la revendication 18, dans lequel
ladite étape d'obtention de ladite pâte métallique comprend le malaxage de ladite poudre de
composé de calcium, de ladite poudre de composé d'aluminium et d'une poudre métallique au moins de tungstène ou de molybdène.

**20.** Un procédé pour former une couche métallisée sur la surface d'un corps fritté en nitrure d'aluminium selon la revendication 18, dans lequel

ladite étape d'obtention de ladite pâte métallique comprend :

une opération de mélange préalable de ladite poudre de composé de calcium et de ladite poudre de composé d'aluminium, et de cuisson pour obtenir une substance cuite, et

une opération de malaxage d'une poudre de ladite substance cuite avec une poudre métallique au moins de tungstène ou de molybdène pour obtenir ladite pâte métallique.

**Revendications pour les Etats contractants suivants : FR, IT**

**1.** Un corps fritté en nitrure d'aluminium ayant une couche métallisée sur sa surface,

ladite couche métallisée contenant :

au moins un métal choisi parmi le tungstène et le molybdène ;

au moins un composé d'aluminium choisi parmi le nitrure d'aluminium, l'oxyde d'aluminium et l'oxynitrure d'aluminium ; et

de l'oxyde de calcium.

**2.** Un corps fritté en nitrure d'aluminium selon la revendication 1, dans lequel

ladite couche métallisée contient 40 à 98 % en poids dudit métal, 1 à 25 % en poids dudit composé d'aluminium et 1 à 35 % en poids d'oxyde de calcium.

**3.** Un corps fritté en nitrure d'aluminium selon la revendication 1, dans lequel

ledit métal est le tungstène et ledit composé d'aluminium est l'oxyde d'aluminium,

ladite couche métallisée contenant 1 à 10 % en poids d'oxyde d'aluminium et 1 à 20 % en poids d'oxyde de calcium.

**4.** Un corps fritté en nitrure d'aluminium selon la revendication 1, dans lequel

ledit métal est le molybdène et ledit composé d'aluminium est l'oxyde d'aluminium,

ladite couche métallisée contenant 1 à 10 % en poids d'oxyde d'aluminium et 1 à 35 % en poids d'oxyde de calcium.

**5.** Un corps fritté en nitrure d'aluminium selon la revendication 1, dans lequel

ledit métal est le tungstène et ledit composé d'aluminium est l'oxyde d'aluminium,

ladite couche métallisée contenant 1 à 10 % en poids d'oxyde d'aluminium et 10 à 20 % en poids d'oxyde de calcium.

**6.** Un corps fritté en nitrure d'aluminium selon la revendication 1, dans lequel

ledit métal est le tungstène et ledit composé d'aluminium est l'oxyde d'aluminium,

ladite couche métallisée contenant 1 à 10 % en poids d'oxyde d'aluminium et 3 à 15 % en poids d'oxyde de calcium.

**7.** Un corps fritté en nitrure d'aluminium selon la revendication 1, dans lequel

ledit métal est le tungstène et ledit composé d'aluminium est l'oxyde d'aluminium,

ladite couche métallisée contenant 1 à 5 % en poids d'oxyde d'aluminium et 1 à 15 % en poids d'oxyde de calcium.

**8.** Un corps fritté en nitrure d'aluminium selon la revendication 1, dans lequel

ledit métal est le molybdène et ledit composé d'aluminium est l'oxyde d'aluminium,

ladite couche métallisée contenant 1 à 10 % en poids d'oxyde d'aluminium et 15 à 35 % en poids d'oxyde de calcium.

**9.** Un corps fritté en nitrure d'aluminium selon la revendication 1, dans lequel

ledit métal est le molybdène et ledit composé d'aluminium est l'oxyde d'aluminium,

ladite couche métallisée contenant 1 à 7 % en poids d'oxyde d'aluminium et 1 à 35 % en poids d'oxyde de calcium.

**10.** Un corps fritté en nitrure d'aluminium selon la revendication 1, dans lequel
ledit métal est le molybdène et ledit composé d'aluminium est l'oxyde d'aluminium,
ladite couche métallisée contenant 1 à 5 % en poids d'oxyde d'aluminium et 1 à 25 % en poids d'oxyde de calcium.

**11.** Un corps fritté en nitrure d'aluminium selon la revendication 1 conçu pour former une partie d'un substrat d'un boîtier pour un dispositif semi-conducteur.

**12.** Un corps fritté en nitrure d'aluminium selon la revendication 11, dans lequel
ledit métal est le tungstène et ledit composé d'aluminium est l'oxyde d'aluminium,
ladite couche métallisée contenant 1 à 10 % en poids d'oxyde d'aluminium et 10 à 20 % en poids d'oxyde de calcium.

**13.** Un corps fritté en nitrure d'aluminium selon la revendication 11, dans lequel
ledit métal est le molybdène et ledit composé d'aluminium est l'oxyde d'aluminium,
ladite couche métallisée contenant 1 à 10 % en poids d'oxyde d'aluminium et 15 à 35 % en poids d'oxyde de calcium.

**14.** Un corps fritté en nitrure d'aluminium selon la revendication 1 conçu pour former une partie d'un refroidisseur d'un dispositif semi-conducteur.

**15.** Un corps fritté en nitrure d'aluminium selon la revendication 14, dans lequel
ledit métal est le tungstène et ledit composé d'aluminium est l'oxyde d'aluminium,
ladite couche métallisée contenant 1 à 10 % en poids d'oxyde d'aluminium et 3 à 15 % en poids d'oxyde de calcium.

**16.** Un corps fritté en nitrure d'aluminium selon la revendication 14, dans lequel
ledit métal est le molybdène et ledit composé d'aluminium est l'oxyde d'aluminium,
ladite couche métallisée contenant 1 à 7 % en poids d'oxyde d'aluminium et 1 à 35 % en poids d'oxyde de calcium.

**17.** Un corps fritté en nitrure d'aluminium selon la revendication 1 conçu pour former une partie d'un capuchon pour assurer l'étanchéité à l'air d'un boîtier pour un dispositif semi-conducteur.

**18.** Un procédé pour former une couche métallisée sur la surface d'un corps fritté en nitrure d'aluminium comprenant :
une étape de préparation d'un corps fritté en nitrure d'aluminium préalablement cuit pour qu'il ait une configuration déterminée ;
une étape d'obtention d'une pâte métallique au moins de tungstène ou de molybdène, ladite pâte contenant une poudre d'au moins un composé du calcium, choisi parmi l'oxyde de calcium, le nitrate de calcium et le carbonate de calcium, et une poudre d'au moins un composé d'aluminium, choisi parmi le nitrure d'aluminium, l'oxyde d'aluminium et l'oxynitrure d'aluminium ;
une étape de revêtement de la surface dudit corps fritté en nitrure d'aluminium avec ladite pâte métallique ; et
une étape de cuisson dudit corps fritté en nitrure d'aluminium revêtu de ladite pâte métallique dans une atmosphère inerte.

**19.** Un procédé pour former une couche métallisée sur la surface d'un corps fritté en nitrure d'aluminium selon la revendication 18, dans lequel
ladite étape d'obtention de ladite pâte métallique comprend le malaxage de ladite poudre de composé de calcium, de ladite poudre de composé d'aluminium et d'une poudre métallique au moins de tungstène ou de molybdène.

**20.** Un procédé pour former une couche métallisée sur la surface d'un corps fritté en nitrure d'aluminium selon la revendication 18, dans lequel
ladite étape d'obtention de ladite pâte métallique comprend :
une opération de mélange préalable de ladite poudre de composé de calcium et de ladite poudre de composé d'aluminium, et de cuisson pour obtenir une substance cuite, et

25

une opération de malaxage d'une poudre de ladite substance cuite avec une poudre métallique au moins de tungstène ou de molybdène pour obtenir ladite pâte métallique.

# FIG.1

| STEP I | PREPARE ALUMINUM NITRIDE SINTERED BODY |
|---|---|

| STEP II | KNEAD CALCIUM COMPOUND POWDER, ALUMINUM COMPOUND POWDER AND METAL POWDER. OF W OR Mo TO PROVIDE METAL PASTE |
|---|---|

| STEP III | COAT METAL PASTE ON SURFACE OF ALUMINUM NITRIDE SINTERED BODY |
|---|---|

| STEP IV | FIRE ALUMINUM NITRIDE SINTERED BODY COATED WITH METAL PASTE IN INERT ATMOSPHERE |
|---|---|

# FIG.2

STEP I
```
PREPARE ALUMINUM NITRIDE SINTERED
BODY
```

STEP II
```
PREVIOUSLY MIX CALCIUM COMPOUND
POWDER WITH ALUMINUM COMPOUND
POWDER AND FIRE THE SAME TO
PROVIDE FIRED SUBSTANCE
```

STEP III
```
KNEAD POWDER OF FIRED SUBSTANCE
WITH METAL POWDER OF W OR Mo TO
PROVIDE METAL PASTE
```

STEP IV
```
COAT METAL PASTE ON SURFACE OF
ALUMINUM NITRIDE SINTERED BODY
```

STEP V
```
FIRE ALUMINUM NITRIDE SINTERED BODY
COATED WITH METAL PASTE IN INERT
ATMOSPHERE
```

## FIG.3

```
┌─────────────────────────────────────────────────────────┐
│  PREPARE ALUMINUM NITRIDE SINTERED SUBSTRATE             │
└─────────────────────────────────────────────────────────┘
                            │
                            ▼
┌─────────────────────────────────────────────────────────┐
│  COAT METAL PASTE ON SURFACE OF ALUMINUM NITRIDE        │
│  SINTERED SUBSTRATE                                      │
└─────────────────────────────────────────────────────────┘
                            │
                            ▼
┌─────────────────────────────────────────────────────────┐
│  PERFORM SCREEN PRINTING ALONG PRESCRIBED PATTERN       │
└─────────────────────────────────────────────────────────┘
                            │
                            ▼
┌─────────────────────────────────────────────────────────┐
│                        DRY                               │
└─────────────────────────────────────────────────────────┘
                            │
                            ▼
┌─────────────────────────────────────────────────────────┐
│  FIRE ALUMINUM NITRIDE SINTERED SUBSTRATE COATED        │
│  WITH METAL PASTE                                        │
└─────────────────────────────────────────────────────────┘
                            │
                            ▼
┌─────────────────────────────────────────────────────────┐
│  PERFORM Ni PLATING ON SURFACE OF METALLIZED            │
│  LAYER                                                   │
└─────────────────────────────────────────────────────────┘
                            │
                            ▼
┌─────────────────────────────────────────────────────────┐
│               SINTER Ni PLATING SURFACE                  │
└─────────────────────────────────────────────────────────┘
                            │
                            ▼
┌─────────────────────────────────────────────────────────┐
│  PERFORM BRAZING ON Ni PLATING SURFACE AND JOIN         │
│  THE SAME WITH LEAD FRAME OR HEAT SINK MEMBER           │
└─────────────────────────────────────────────────────────┘
                            │
                            ▼
┌─────────────────────────────────────────────────────────┐
│          PERFORM Au PLATING ON JUNCTION                  │
└─────────────────────────────────────────────────────────┘
```

FIG.4A

FIG.4B

FIG.4C

## FIG.5

6
1
2
11a
11
4
10

## FIG.6

4
2
1
6

## FIG.8

16
2
9
1

## FIG.7

13
12
12
4
5
12
10
12
10
15
14
1
2
15

## FIG.9A

$$\frac{\text{TENSILE STRENGTH(kg/mm}^2)}{\text{(IN PARENTHESES)}}$$

CaO CONTENT $\left(\frac{CaO}{CaO+Al_2O_3+W}\right)$ (wt.%)

Al₂O₃ CONTENT $\left(\frac{Al_2O_3}{CaO+Al_2O_3+W}\right)$ (wt.%)

FIG:9B

THERMAL RESISTANCE VALUE(°C/W)
(IN PARENTHESES)

FIG.10A

TENSILE STRENGTH (kg/mm$^2$ )
(IN PARENTHESES)

# FIG.10B

THERMAL RESISTANCE VALUE(°C/W)
(IN PARENTHESES)